(19) Europäisches Patentamt
European Patent Office
Office européen des brevets

(11) **EP 1 903 129 A1**

(12) **EUROPEAN PATENT APPLICATION**

(43) Date of publication:
**26.03.2008 Bulletin 2008/13**

(51) Int Cl.:
*C25D 5/08* (2006.01)      *C25D 5/02* (2006.01)
*H05K 3/00* (2006.01)      *H05K 3/24* (2006.01)

(21) Application number: **07076026.9**

(22) Date of filing: **20.11.2003**

(84) Designated Contracting States:
**AT BE BG CH CY CZ DE DK EE ES FI FR GB GR HU IE IT LI LU MC NL PT RO SE SI SK TR**

(62) Document number(s) of the earlier application(s) in accordance with Art. 76 EPC:
**03257344.6 / 1 533 400**

(71) Applicant: **PROCESS AUTOMATION INTERNATIONAL LIMITED**
**Tai Po,**
**New Territories (HK)**

(72) Inventors:
• **Henington, Paul**
  **Tsuen Wan, New Territories,**
  **Hong Kong (CN)**
• **Ng, Kwok Wing**
  **Kwai Chung, New Territories,**
  **Hong Kong (CN)**

• **Leung, Yuk Wah**
  **Yuen Long, New Territories,**
  **Hong Kong (CN)**
• **Chan, Ka Man**
  **Sheung Shui, New Territories,**
  **Hong Kong (CN)**

(74) Representative: **Reeve, Anna Elizabeth et al**
**Lloyd Wise**
**Commonwealth House**
**1-19 New Oxford Street**
**GB-London WC1A 1LW (GB)**

Remarks:
This application was filed on 27.11.2007 as a divisional application to the application mentioned under INID code 62.

(54) **A liquid delivery system for an electroplating apparatus, an electroplating apparatus with such a liquid delivery system, and a method of operating an electroplating apparatus**

(57)      A system for delivering a liquid into a container of an electroplating apparatus is disclosed as including a pipe for receiving the liquid from a liquid source, an outlet for receiving the liquid from the pipe and via which the liquid from the pipe is deliverable into the container, and openings allowing, during operation, the liquid in the container to enter the outlet otherwise than from the pipe.

Fig. 15A

**Description**

This invention relates to a liquid delivery system, e.g. for delivery of liquid electrolyte, for an electroplating apparatus, an electroplating apparatus incorporated with such a liquid delivery system, and a method of operating an electroplating apparatus.

Background of the Invention

In electroplating process, a substrate to be electroplated, e.g. a printed circuit board (PCB), may have a number of small troughs, called "micro via", required to be filled, i.e. by electroplating, with a metal, e.g. copper, contained in an electrolyte delivered into a processing tank of the electroplating apparatus by a number of nozzles. The typical size of a micro via is around $50\mu m$-$200\mu m$ in diameter and around $50\mu m$- $125\mu m$ in depth.

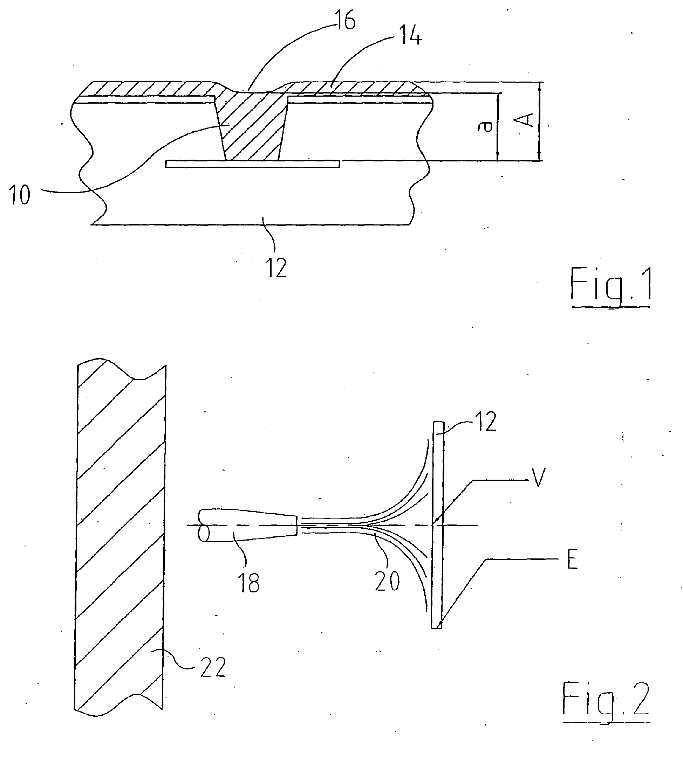

Fig. 1 shows a micro via 10 of a PCB 12 partly filled by a layer 14 of metal, e.g. copper. The fill-up ratio a/A, in which a is the distance between the bottom of the micro via 10 and the bottom of a trough 16 not filled with copper, and A is the distance between the bottom of the micro via 10 and the surface of the layer 14 of copper, is always less than 100%. It has always been an objective in the field to try to so electroplate the PCB 12 that the fill-up ratio is as close to 100% as possible.

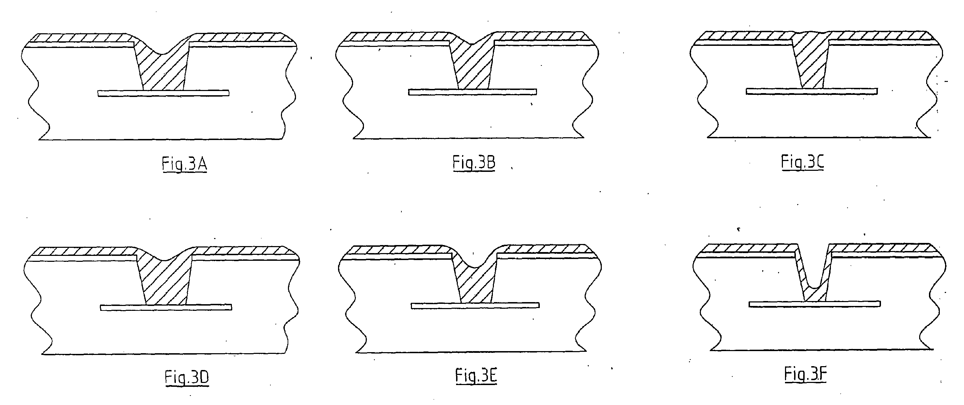

During the electroplating process, and as shown in Fig. 2, a nozzle 18 for delivery of electrolyte 20 is positioned between an anode 22 and the PCB 12, which acts as the cathode. It is found in practice that high impingement flow of electrolyte onto the opening of a micro via of the PCB 12 is required for a satisfactory micro via filling effect. In this connection, Figs. 3A to 3F show the result of experiments conducted on filling of micro via under the conditions shown in Table 1 below:

Table 1

|  | Position of the Micro Via | Electric Current Density |
|---|---|---|
| Fig. 3A | V | 20ASF |
| Fig. 3B | V | 25ASF |
| Fig. 3C | V | 30ASF |
| Fig. 3D | E | 20ASF |
| Fig. 3E | E | 25ASF |
| Fig. 3F | E | 30ASF |

In the above Table 1 and the ensuing discussion, "ASF" stands for "ampere per square feet", and 1 ASF is equivalent to 10.76 ampere per square metre.

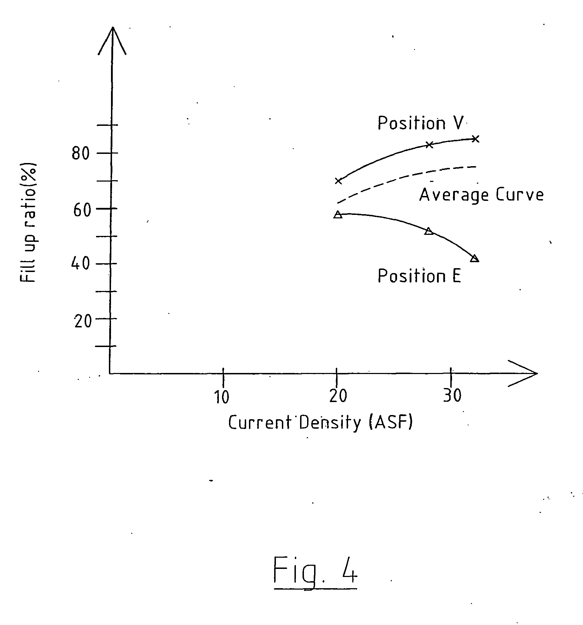

As can be seen in Fig. 2, the position marked "V" is the part on the PCB 12 closest to the mouth of the nozzle 18 and lies on the axis of the nozzle 18, and is thus in the region covered by the jet of electrolyte, whereas the position marked "E" is the part on the PCB 12 furthest from the mouth of the nozzle 18. The results of the above experiments are shown in Fig. 4, in which the Y-axis is the fill-up ratio, in percentage (%), and the X-axis is the electric current density, in ASF. The top curve in Fig. 4 represents the results of micro via filling as shown in Fig. 3A to 3C, the bottom curve in Fig. 4 represents the results of micro via filling as shown in Figs. 3D to 3F, and the middle curve is the arithmetic average of the top and bottom curves.

It can be seen that:

(a) for the same electric current density, the micro via in position V and that in position E have different fill-up ratio;
(b) for micro via in position V, a higher electric current density will bring about a higher fill-up ratio; whereas
(c) for micro via in position E, a lower electric current density will bring about a higher fill-up ratio.

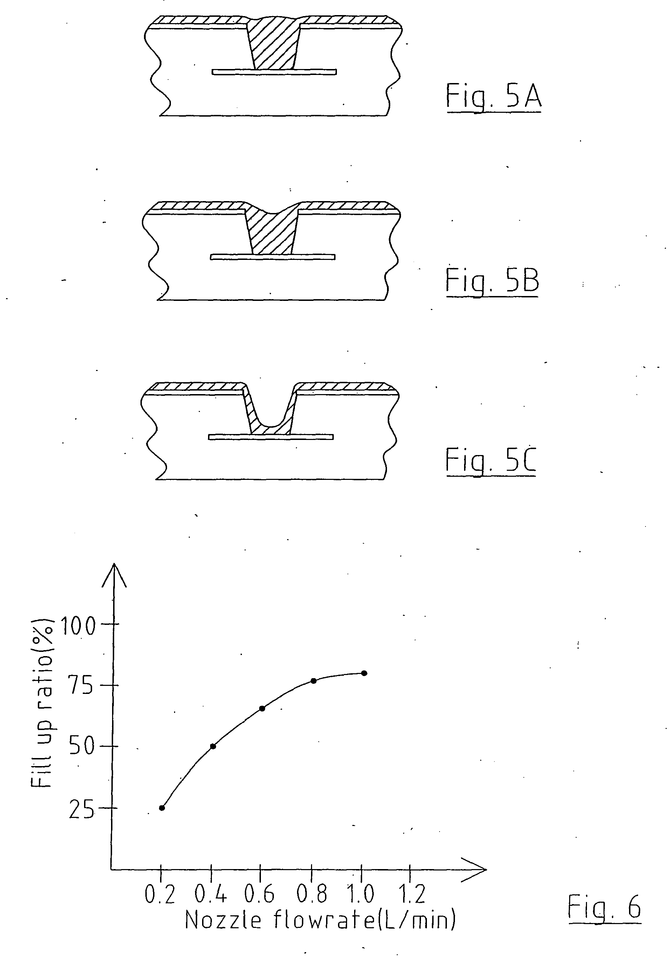

Experiments have also been conducted on the relationship of the fill-up ratio relative to the flow rate of electrolyte delivered by the nozzle, at a fixed current density. Figs. 5A to 5C show results of the experiments conducted on three micro via disposed at the same position relative to the nozzle, at different electrolyte flow rates, all under an electric current density of 25ASF. As summarized in Fig. 6, in which the Y-axis is the fill-up ratio, in percentage (%), and the X-axis is the electrolyte flow rate, in litre per minute (L/min), the results show that the higher the flow rate is, the higher the fill-up ratio is.

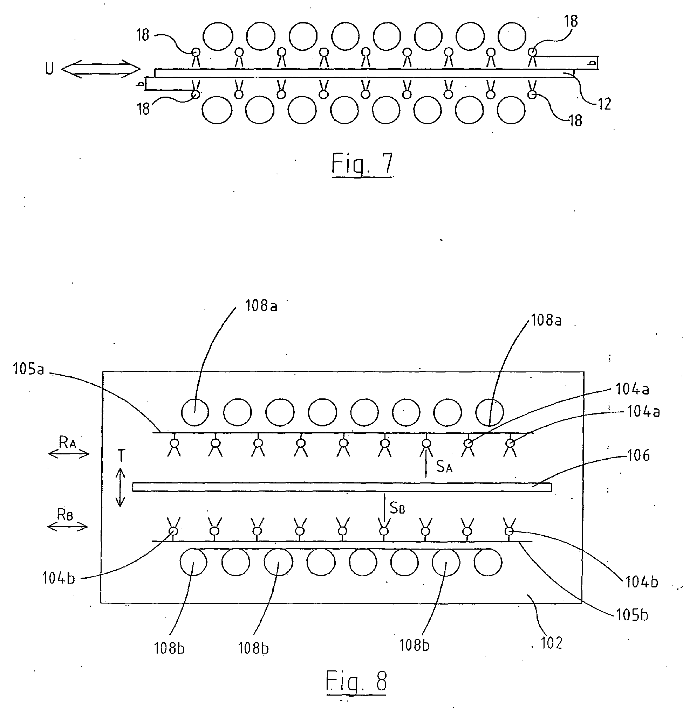

In order to obtain even fill-up ratio and current distribution on the PCB's, it has been proposed to agitate the PCB's in a "knife-edge" manner. By "knife-edge" agitation, it is meant that while the distance $b$ (see Fig. 7) between the nozzles 18 and the PCB 12 is kept constant, the PCB 12 is caused to reciprocate left and right (as shown in the bi-directional arrow U in Fig. 7) or up and down. Such a method, however, suffers from the following disadvantages:

    a. Such a "knife-edge" agitation of the PCB's is only suitable for use in micro via filling.
However, a PCB does not usually only have micro via, but may also have through holes, which require a different manner of movement, e.g. forward and backward movement in which the distance b (see Fig. 7) varies.
b. Due to edging effect, the edges of PCB's will always have thicker plating. A typical method to avoid this is to adjust the anodes and the position of the PCB edges, and to introduce shielding between the anodes and PCB edges. However, as the cathode (i.e. the PCB's) moves relative to the electroplating machine, it is very difficult to adjust the shielding position and the anode position. It is thus also difficult to obtain good plating uniformity on PCB's.

In addition, micro via of different sizes require different electric current density to achieve good via filling result. In general, a high current density is suitable for via of a larger size. However, a high electric current density is prone to create void in via of a smaller size. On the other hand, although a low electric current density is suitable for via of a smaller size, this will usually result in undercut for via of a bigger size. It is thus difficult to produce satisfactory result when electroplating a substrate with micro via of different sizes.

It is thus an object of the present invention to provide a liquid delivery system for an electroplating apparatus, an electroplating apparatus with such a liquid delivery system, an electroplating apparatus with a current distributor, and a method of operating an electroplating machine, in which the aforesaid shortcomings are mitigated, or at least to provide a useful alternative to the public.

Such and other objects of this invention will become apparent in the ensuing discussion.

Summary of the Invention

According to a first aspect of the present invention, there is provided a liquid delivery system for an electroplating apparatus, said system including at least two liquid outlets which are fixedly spaced apart from each other for simultaneous movement and adapted to deliver a liquid into said apparatus, wherein at least a first of said liquid outlets is adapted to deliver said liquid into said apparatus generally along a path, and wherein said liquid outlets are movable on a plane substantially perpendicular to said path.

According to a second aspect of the present invention, there is provided an electroplating apparatus incorporated with a liquid delivery system, said system including at least two liquid outlets which are fixedly spaced apart from each other and adapted to deliver a liquid into said apparatus, wherein at least a first of said liquid outlets is adapted to deliver said liquid into said apparatus generally along a path, and wherein said liquid outlets are movable on a plane substantially perpendicular to said path.

According to a third aspect of the present invention, there is provided an electroplating apparatus adapted for electroplating at least a substrate, including anode means, container means for containing an electrolyte, means for delivering said electrolyte into said container, and means for controlling the rate of flow of said electrolyte from said delivering means onto different parts of said substrate.

According to a fourth aspect of the present invention, there is provided a system for delivering a liquid into a container of an electroplating apparatus, said system including pipe means for receiving said liquid from a liquid source, at least an outlet adapted to receive said liquid from said pipe means and *via* which said liquid from said pipe means is deliverable into said container, and means allowing, during operation, said liquid in said container to enter said outlet otherwise than from said pipe means.

According to a fifth aspect of the present invention, there is provided an electroplating apparatus incorporated with a system for delivering a liquid into a container of said electroplating apparatus, said system including pipe means for receiving said liquid from a liquid source, at least an outlet adapted to receive said liquid from said pipe means and *via* which said liquid from said pipe means is deliverable into said container, and means allowing, during operation, said liquid in said container to enter said outlet otherwise than from said pipe means.

According to a sixth aspect of the present invention, there is provided a method of operating an electroplating apparatus, including the steps of (a) operating said electroplating apparatus at a first current density for a first period of time; and (b) subsequently operating said electroplating apparatus at a higher second current density for a second period of time.

Brief Description of the Drawings

Examples of the present invention will now be described, by way of example only, with reference to the accompanying drawings, in which:

Fig. 1 shows a micro via of a PCB partly filled by a layer of copper;

Fig. 2 shows the positioning of an anode, a nozzle and a PCB in an electroplating apparatus;

Figs. 3A to 3F show the results of filling of six micro via at different positions relative to the nozzle and at different current densities;

Fig. 4 is a diagram summarizing the results shown in Fig. 3A to 3F;

Figs. 5A to 5C show the results of filling of three micro via at the same current density, but under different rates of flow of electrolyte from the nozzle;

Fig. 6 is a diagram summarizing the results shown in Figs. 5A to 5C;

Fig. 7 shows a first conventional electrolyte delivery system for an electroplating apparatus;

Fig. 8 shows an electrolyte delivery system according to a first embodiment of the present invention;

Figs. 9A and 9B show the manner of movement of the nozzles in the electrolyte delivery system shown in Fig. 8;

Fig. 10 shows an electrolyte delivery system according to a second embodiment of the present invention;

Fig. 11 shows part of the electrolyte delivery system shown in Fig. 10 at a larger scale;

Fig. 12 shows a current distributor in the electrolyte delivery system shown in Fig. 10;

Figs. 13A and 13B show a second conventional electrolyte delivery system for an electroplating apparatus;

Figs. 14A and 14B show a third conventional electrolyte delivery system for an electroplating apparatus;

Figs. 15A and 15B show an electrolyte delivery system according to a third embodiment of the present invention;

Figs. 16A and 16B show an electrolyte delivery system according to a fourth embodiment of the present invention;

Figs. 17A and 17B show in more detail the electrolyte delivery system shown in Figs. 16A and 16B, in which Fig. 17A is a sectional view taken along the line Z-Z of Fig. 17B; and

Figs. 18A to 18B show results of experiments conducted on micro via of different sizes, under different magnitudes of electric current density, and under different modes of operation.

Detailed Description of the Preferred Embodiments

Referring now to Fig. 8, such shows a schematic diagram of a liquid delivery system according to the present invention, for an electroplating apparatus, in particular for delivering a liquid electrolyte into a tank 102 of the electroplating apparatus. The liquid delivery system includes two rows of nozzles 104a, 104b for delivering the electrolyte into the tank 102. The nozzles 104a are fixedly spaced apart from one another for simultaneous movement. Similarly, the nozzles 104b are also fixedly spaced apart from one another for simultaneous movement. In particular, the nozzles 104a, 104b are joined with a respective pipe 105a, 105b for receiving the electrolyte therefrom. It should be understood that the number of rows of nozzles may be one or more than two, depending on the specific need and design.

As shown in Fig. 8, substrates, e.g. a number of printed circuit boards (PCB's), of which only one PCB 106 is shown in Fig. 8, may be lowered, e.g. by a PCB carrier, e.g. flight bar (not shown), into the tank 102 between the rows of nozzles 104a, 104b. During the electroplating process, the PCB 106 remains substantially stationary relative to the tank 102 of the electroplating machine. The rows of nozzles 104a, 104b are then caused to reciprocate along a respective straight line along a plane which is perpendicular to the directions indicated by the arrows $S_A$, $S_B$ in which the nozzles 104a, 104b deliver the electrolyte into the tank 102. The rows of nozzles 104a, 104b may thus, for example, reciprocate left and right, as indicated by the bi-directional arrows $R_A$, $R_B$ in Fig. 8, or up and down, i.e. in an out of the plane of the paper.

As the weight of the piping and nozzles 104a, 104b is much less that of the PCB 106 and the flight bar (not shown), the weight of the movable part is thus much reduced, and consequently less power is required for effecting movement thereof.

On the side of the rows of nozzles 104a, 104b away from the path of movement of the PCB's 106 is a respective row of anodes 108a, 108b. During operation, the anodes 108a, 108b are electrically connected to a source of electricity, and the PCB 106 in the tank 102 will act as a cathode, thus allowing an electric field to exist in the tank 102 between the PCB 106 and the anodes 108a, 108b, to thereby deposit a metal, e.g. copper, in the electrolyte onto appropriate locations in and on the PCB 106. The intensity of the electric field (as measured in ASF or ampere per square metre) may be adjusted, as desired.

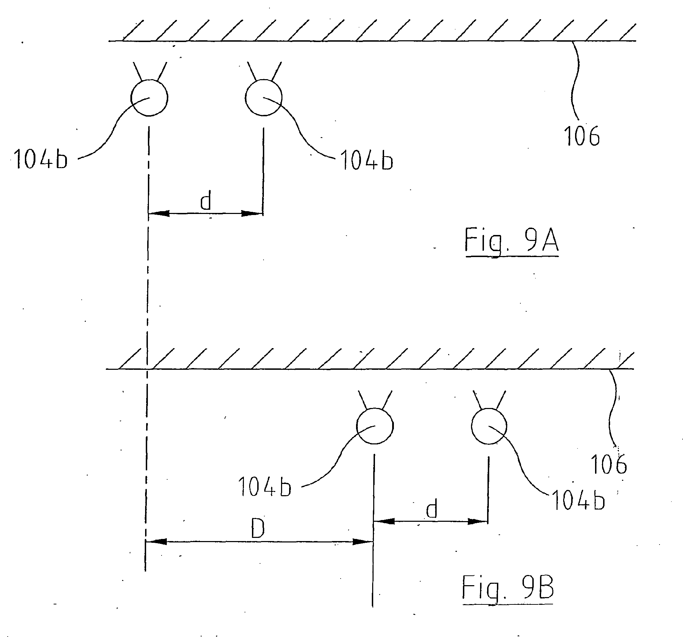

Turning to Figs. 9A and 9B, such show respectively the left-most position and the right-most position of movement of a pair of adjacent nozzles 104b. It is found in practice that, in order to achieve the most appropriate electrolyte jet coverage, the ratio d/D, in which d is the distance between two adjacent nozzles 104a, and D is the distance between the left-most position and the right-most position (also called the "stroke length") of a respective nozzle 104a, is preferably from 1/2 to 3/5.

In such an arrangement, the relative distance between the cathodes (i.e. PCB's 106) and the anodes 108a, 108b remains unchanged, thus making it easier to obtain uniformity of plating effect on the PCB's 106.

Such an electrolyte delivery system may also be used in combination with other systems. For example, the PCB's 106 may, if necessary, be caused to move to and fro, e.g. as indicated in the bi-directional arrow T shown in Fig. 8, towards and away from the PCB 106 to allow through holes to be satisfactorily electroplated.

While the above arrangement is most suitable for use in a hoist-type electroplating machine, such may not be required in a conveyor-type electroplating machine in which the substrates are carried by a conveyor to move through a processing tank. As discussed above, and as shown in Figs. 2 to 4, the best combination for micro via filling is to introduce a higher electric current density at position V, and a lower electric current density at position E.

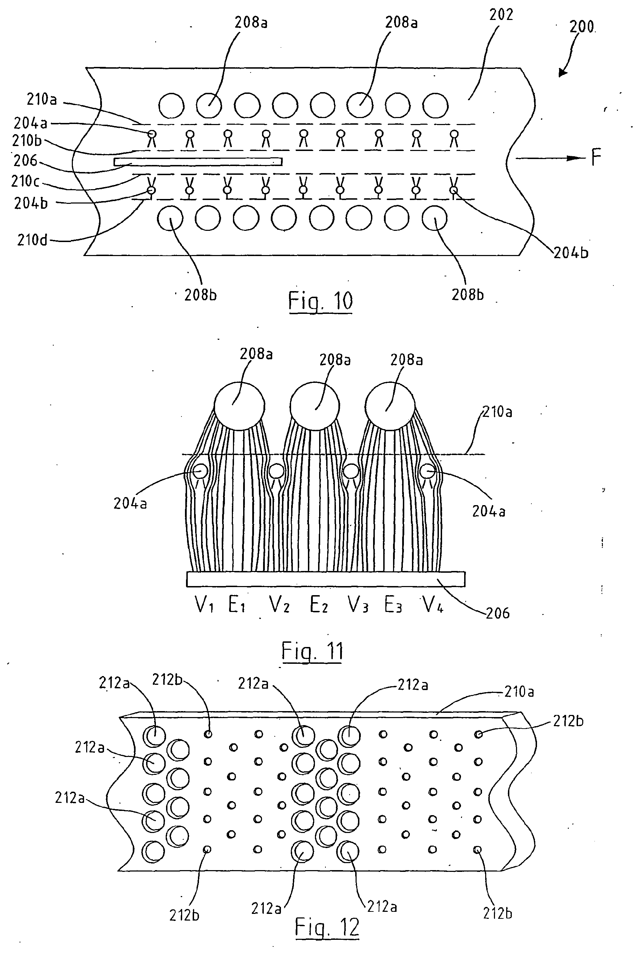

An electroplating apparatus, generally designated as 200, for achieving such an effect is schematically shown in Fig. 10. The apparatus 200 includes at least a processing tank 202 into which an electrolyte may be introduced by a number of nozzles 204a, 204b. Substrates, e.g. PCB's (of which only one PCB 206 is shown in Fig. 10), may be moved by conveyor (not shown) through the tank 202 in a direction indicated by the arrow F. On a respective side of the rows of nozzles 204a, 204b away from the path of movement of the PCB's 206 in the tank 202 is a respective row of anodes 208a, 208b.

Disposed between the row of anodes 208a and the row of nozzles 204a is a first electric current distributor 210a; between the row of nozzles 204a and the path of movement of the PCB's 206 in the tank 202 is a second electric current distributor 210b; between the row of nozzles 204b and the path of movement of the PCB's 206 in the tank 202 is a third electric current distributor 21 Oc; and between the row of nozzles 204b and the row of anodes 208b is a fourth electric current distributor 210d. It should be understood that satisfactory result can be obtained if only one of the current distributors 210a, 21 0b is present and only one of the current distributors 210c, 210d is present. The present arrangement of four current distributors 210a, 210b, 210c, 210d as shown in Fig. 10 is only optional and is provided to achieve a better result.

As shown in Fig. 11, with the installation of the current distributor 210a, the electric field existing between the anodes 208a and the PCB 206 (which acts as the cathode) is varied or re-distributed such that a higher electric current density is directed towards locations $V_1$, $V_2$, $V_3$ and $V_4$, which are closest to the respective nozzle 204a, whereas a lower electric current density is directed towards locations $E_1$, $E_2$ and $E_3$, which are regions on the PCB 206 equidistant from two adjacent nozzles 204a.

As can be seen more clearly in Fig. 12, the current distributor 210a is a porous plate made of an electrically insulating material, e.g. polypropylene (PP) or polyvinyl chloride (PVC). Provided on the current distributor 210a are groups of through holes 212a, 212b, in which the through holes 212a are of a larger size than the through holes 212b. Because of the insulating nature of the current distributor 210a, an electric field can only exist between the anodes 208a and the PCB 206 *via* the through holes 212a, 212b. Because of the different sizes of the through holes 212a, 212b, a larger electric current density exists through the through holes 212a, whereas a smaller electric current density exists through the through holes 212b. It should be understood that the through holes 212a, 212b, although shown here as being circular in shape, may be of other shapes, e.g. elongate slots and gaps, provided that such allows electricity to pass through.

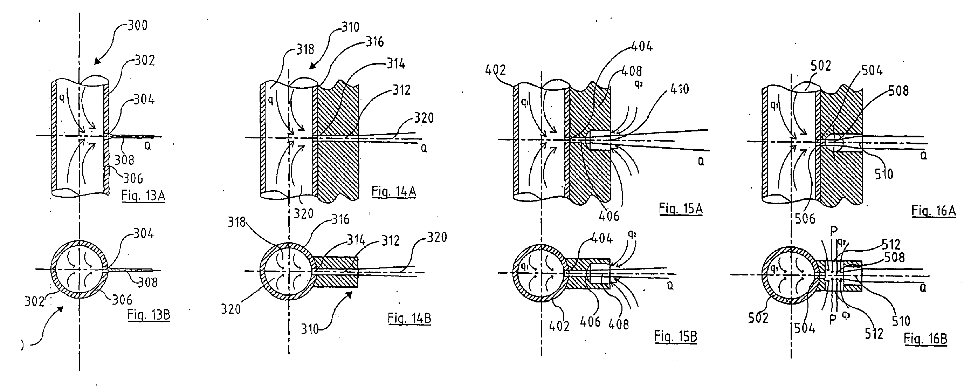

Figs. 13A and 13B show a further conventional arrangement of an electrolyte delivery system for an electroplating apparatus, generally designated as 300. In this arrangement, a supply pipe 302 is provided with at least a hole 304 through its wall 306, allowing exit of electrolyte 308 from the pipe 302 into a tank of the electroplating apparatus. The rate of flow Q, e.g. measured in terms of litre per minute, of electrolyte through the hole 304 into the tank is equal to the rate of flow q of electrolyte from the pipe 302 into the hole 304. Figs. 14A and 14B show yet a further conventional arrangement of an electrolyte delivery system generated designated as 310, for an electroplating apparatus. In this arrangement, a channel 312 is provided adjacent to and in a communicable relationship with a hole 314 through a wall 316 of a supply pipe 318. Electrolyte 320 in the supply pipe 318 first enters the hole 314, then through the channel 312, before it enters a tank of the electroplating apparatus. As in the case of the arrangement shown in Figs. 13A and 13B and discussed above, the rate of flow Q of electrolyte from the channel 312 into the tank is equal to the rate of flow q of electrolyte from the pipe 318 into the hole 314.

As discussed above, the higher the flow rate of the electrolyte is, the higher the fill-up ratio is. Arrangements have thus here been devised to increase the rate of flow of electrolyte into the tank without necessarily increasing the rate of flow of electrolyte into the supply pipe, and thus the rate of flow of electrolyte from the supply pipe to the respective holes on the supply pipe. Such is particularly advantageous as the spacing between the PCB's and the anodes is very small and may not allow large pipe work to be installed.

A first arrangement according to the present invention is shown in Figs. 15A and 15B. In this arrangement, a supply pipe 402 is provided with a number of holes, of which one hole 404 is shown in Figs. 15A and 15B. The hole 404 is connected and in a liquid communicable relationship with a channel 406, leading to a widened space 408 with a flared mouth 410. It is found in practice that, during operation, when electrolyte exits through the channel 406 into the space 408 and enters a tank of the electroplating apparatus, electrolyte adjacent to the flared mouth 410 is drawn by the passing electrolyte into the mouth 410 in a direction generally opposite to the direction of exit of the electrolyte, and mixes with the exiting electrolyte. The aggregate rate of flow $Q$ of electrolyte from the space 408 into the tank is equal to sum of the rate of flow $q_1$ of electrolyte from the pipe 402 into the hole 404 and the rate of flow $q_2$ of electrolyte drawn from the tank into the mouth 410 of the space 408. It can be seen that some of the electrolyte thus enters the space 408 directly from the tank and not from the pipe 402. It can also be seen that the channel 406 is narrower than the internal diameter of the pipe 402 and than the space 408.

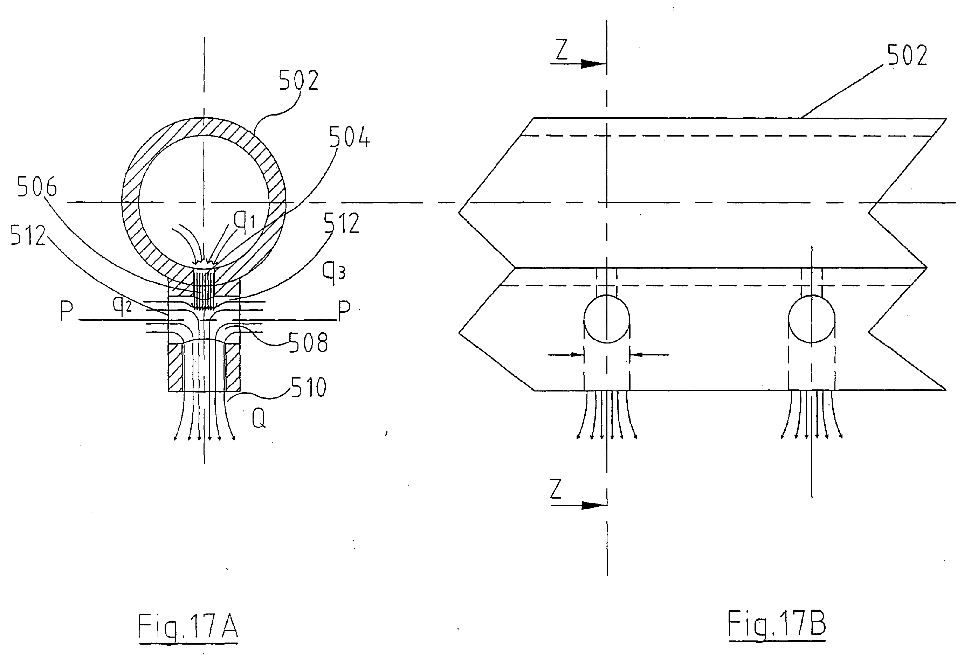

A second arrangement according to the present invention is shown in Figs. 16A to 17B. In this arrangement, a supply pipe 502 is provided with a number of holes, of which one hole 504 is shown in Fig. 16A and 16B. The hole 504 is connected with a channel 506 leading to a through hole 508 whose longitudinal axis P-P is generally perpendicular to the direction of flow of the electrolyte from the channel 506 into the through hole 508. After passing through the through hole 508, the electrolyte enters a widened bore 510, before entering a tank of the electroplating apparatus. It is found in practice that, with such an arrangement, electrolyte in the tank adjacent to two openings 512 of the through hole 508 is drawn into the through hole 508 and mixes with the electrolyte in the through hole 508, and enters the bore 510 before entering the tank again. The direction of entry of electrolyte from the tank into the through hole 508 is therefore generally perpendicular to the direction of flow of electrolyte from the channel 506 to the bore 510, and subsequently into the tank. The aggregate rate of flow Q of electrolyte from the bore 510 into the tank is equal to sum of the rate of flow $q_1$ of electrolyte from the pipe 502 into the hole 504 and the rates of flow $q_2$, $q_3$ of electrolyte drawn from the tank through the openings 512 into the through hole 512. It can be seen that some of the electrolyte thus enters the bore 510 directly from the tank and not from the pipe 502. It can also be seen that the channel 506 is narrower than the internal diameter of the pipe 502 and than the bore 510.

It can be seen that the above makes use of eductor effect to increase the rate of flow of electrolyte from the nozzles to the PCB's. An eductor or liquid ejector is an appliance allowing a region of slow moving or even static fluid (e.g. liquid) to be entrained into a generally high-speed jet of fluid in such a way to acquire a significant proportion of the kinetic energy of the latter. The result can be a combined fluid jet of a flow rate of several times the original high kinetic energy jet. However, the size of a conventional eductor is rather large and is therefore not convenient or suitable for use here. The arrangements according to the present invention and discussed above are, on the other hand, space-saving, allow for easy manufacturing, and are of a relatively low cost.

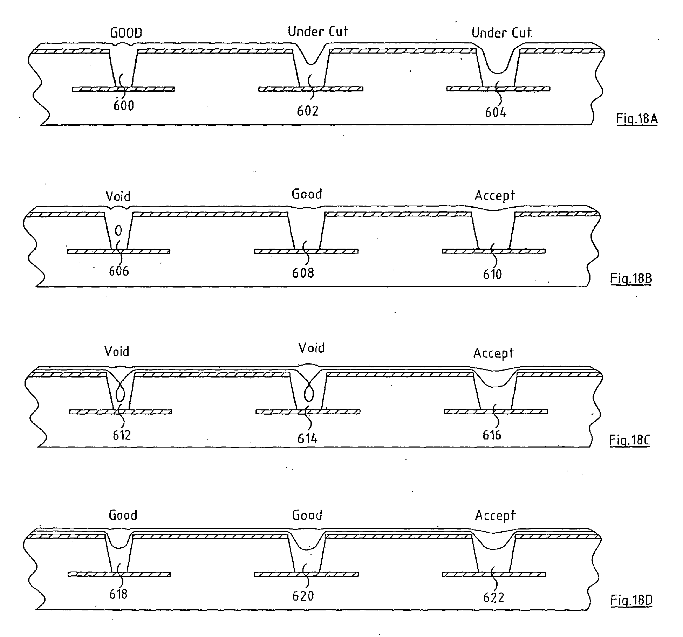

As discussed above, in general, a high current density is suitable for filling micro via of a larger size. However, a high electric current density is prone to create void in micro via of a smaller size. On the other hand, although a low electric current density is suitable for filling micro via of a smaller size, this will usually result in undercut for micro via of a bigger size. Such are borne out by experiments. Fig. 18A shows the results of filling of a row of three micro via 600, 602, 604, all of a depth of 75μm. The via 600 is of a diameter of around 75μm, the via 602 of a diameter of around 100μm, and the via 604 of a diameter of around 125μm. An electric field of a current density of 25 ASF was applied for 55 minutes, and the result of the filling is shown in Fig. 18A. It can be seen that good result was only obtained in the via 600, whereas under cuts appeared in the via 602 and 604.

The next experiment was also conducted on three micro via of a depth of 75μm, the micro via 606 of a diameter of around 75μm, the via 608 of a diameter of around 100μm, and the via 610 of a diameter of around 125μm. An electric field of a current density of 30 ASF was applied for 46 minutes, thus achieving the same magnitude of ampere-hour as in the first experiment discussed above, and the result of the filling is shown in Fig. 18B. It can be seen that although good and acceptable results were obtained for the via 608, 610, a void appeared in the via 606.

A third experiment was also conducted on three micro via of a depth of 75μm, the micro via 612 of a diameter of around 75 μm, the via 614 of a diameter of around 100μm, and the via 616 of a diameter of around 125μm. An electric field of a current density of 30 ASF was applied for 27.5 minutes, then an electric field of a current density of 20 ASF was applied for 27.5 minutes, thus achieving the same magnitude of ampere-hour as in the first and the second experiments discussed above, and the result of the filling is shown in Fig. 18C. It can be seen that although an acceptable result was obtained for the via 616, a void appeared in each of the via 612, 614.

It is found in practice that a much more acceptable result can be obtained by first applying an electric field of a lower current density for a first period of time, and then applying an electric field of a higher current density for a second period of time. The two periods of time may preferably be the same. Such is borne out by a fourth experiment also conducted on three micro via of a depth of 75μm, the micro via 618 of a diameter of around 75μm, the via 620 of a diameter of around 100μm, and the via 622 of a diameter of around 125 μm. An electric field of a current density of 20 ASF was applied for 27.5 minutes, then an electric field of a current density of 30 ASF was applied for 27.5 minutes, thus achieving the same magnitude of ampere-hour as in the first, second and third experiments discussed above, and the result of the filling is shown in Fig. 18D. It can be seen that the filling result of each of all these three via 618, 620 and 622 was either good or at least acceptable.

It is thus found in practice that for a PCB with micro via of more than one size, it is very difficult to fill up all these via by a single-step current density process. The present invention adopts a process with step-wise application of higher current density that can avoid voids from forming in the smaller via, while depositing enough copper in the bigger via. It is found in practice that the number of steps of successively higher electric current density may be more than two, e.g. three or even four, depending on the specific need of the user.

It is also found in practice that the step-wise application of successively higher electric current density for the electroplating of the substrates can, for the same satisfactory plating result, reduce the total plating time. For example, the maximum single step current density, in order to avoid void, is 25 ASF, and the plating time is 30 minutes. The total current employed is 25 x 30/60 ampere-hour per square feet, i.e. 12.5 ampere-hour per square feet. To achieve the same result, i.e. without any void, a step-wise method as follows may be employed:

$$25 \text{ ASF x } 20 \text{ minutes}$$

$$30 \text{ ASF x } 8.33 \text{ minutes}$$

The total current employed is 25 x 20/60 + 30 x 8.33/60 ampere hour per square feet, i.e. also 12.5 ampere-hour per square feet. The process time is however 28.33 minutes only.

It should be understood that the above only illustrates examples whereby the present invention may be carried out, and that various modifications and/or alterations may be made thereto without departing from the spirit of the invention.

It should also be understood that certain features of the invention, which are, for clarity, described in the context of separate embodiments, may be provided in combination in a single embodiment. Conversely, various features of the invention which are, for brevity, described in the context of a single embodiment, may also be provided separately or in any appropriate sub-combinations.

**Claims**

1. A system for delivering a liquid into a container of an electroplating apparatus, said system including pipe means for receiving said liquid from a liquid source, at least an outlet adapted to receive said liquid from said pipe means and *via* which said liquid from said pipe means is deliverable into said container, and means allowing, during operation, said liquid in said container to enter said outlet otherwise than from said pipe means.

2. A system according to Claim 1 further including a first channel in a liquid communicable relationship with said pipe means and said outlet, wherein said first channel is narrower than the internal diameter of said pipe means and said outlet.

3. A system according to Claim 1 wherein said outlet includes a widened mouth portion allowing entry of said liquid in said container into said outlet.

4. A system according to Claim 3 wherein, during operation, said liquid in said container is allowed to enter said outlet in a direction generally opposite to the direction in which said liquid exits from said outlet into said container.

5. A system according to Claim 1 wherein said pipe means is in a liquid communicable relationship with said outlet *via* a second channel, and wherein said second channel has at least an opening allowing said liquid in said container to enter.

6. A system according to Claim 5 wherein said second channel has at least two openings allowing said liquid in said container to enter.

7. A system according to Claim 5 wherein said opening allows said liquid in said container to enter in a direction generally perpendicular to the direction in which said liquid exits said outlet.

8. An electroplating apparatus incorporated with a system according to any one of Claims 1 to 7.

_Fig.1_

_Fig.2_

EP 1 903 129 A1

Fig.3C

Fig.3F

Fig.3B

Fig.3E

Fig.3A

Fig.3D

9

Fig. 4

Fig. 5A

Fig. 5B

Fig. 5C

Fig. 6

Fig. 7

Fig. 8

Fig. 9A

Fig. 9B

208a    208a    202    200

210a
204a
210b
206
210c
204b

210d

208b    Fig. 10    208b    204b

F

208a    208a    208a

210a

204a    204a

V₁  E₁  V₂  E₂  V₃  E₃  V₄    206

Fig. 11

212a  212b    212a    212a    210a

212a    212b

212a

212a

212b    212a    212a    212b

Fig. 12

Fig. 13A

Fig. 13B

Fig. 14A

Fig. 14B

Fig. 15A

Fig. 15B

Fig. 16A

Fig. 16B

Fig.17A

Fig.17B

502

504

506

512

512

q₁

q₃

q₂

P

P

508

510

Q

Z

Z

502

EP 1 903 129 A1

GOOD       Under Cut       Under Cut

600       602       604       Fig.18A

Void       Good       Accept

606       608       610       Fig.18B

Void       Void       Accept

612       614       616       Fig.18C

Good       Good       Accept

618       620       622       Fig.18D

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/196904 A1 (KEMPEN HEIN VAN [NL] ET AL VAN KEMPEN HEIN [NL] ET AL) 23 October 2003 (2003-10-23) * the whole document * ----- | 1-5,8 | INV. C25D5/08 C25D5/02 H05K3/00 H05K3/24 |
| X | WO 99/58257 A (TYCO PRINTED CIRCUIT GROUP INC [US]; JOSEFOWICZ JACK Y [US]) 18 November 1999 (1999-11-18) * page 6, line 24 - page 7, line 22; figures 2,5 * ----- | 1-5,8 | |
| X | EP 0 510 586 A (CASTLE ROBERT LEE [US]) 28 October 1992 (1992-10-28) * column 3, line 33 - column 4, line 40; figures 1,2,3A * ----- | 1-8 | |

| TECHNICAL FIELDS SEARCHED (IPC) |
|---|
| C25D H05K |

The present search report has been drawn up for all claims

| Place of search | Date of completion of the search | Examiner |
|---|---|---|
| Munich | 15 February 2008 | Fitzpatrick, John |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 07 6026

This annex lists the patent family members relating to the patent documents cited in the above-mentioned European search report.
The members are as contained in the European Patent Office EDP file on
The European Patent Office is in no way liable for these particulars which are merely given for the purpose of information.

15-02-2008

| Patent document cited in search report | | Publication date | Patent family member(s) | | Publication date |
|---|---|---|---|---|---|
| US 2003196904 | A1 | 23-10-2003 | NONE | | |
| WO 9958257 | A | 18-11-1999 | AU | 2495199 A | 29-11-1999 |
| | | | EP | 1087844 A1 | 04-04-2001 |
| | | | US | 6048584 A | 11-04-2000 |
| EP 0510586 | A | 28-10-1992 | DE | 69208281 D1 | 28-03-1996 |
| | | | DE | 69208281 T2 | 08-08-1996 |
| | | | US | 5149411 A | 22-09-1992 |

EPO FORM P0459

For more details about this annex : see Official Journal of the European Patent Office, No. 12/82